# EUROPÄISCHE PATENTSCHRIFT

(11) **EP 0 310 922 B1**
(45) Veröffentlichungstag und Bekanntmachung des Hinweises auf die Patenterteilung: **13.12.1995**
(21) Anmeldenummer: 88115928.9
(22) Anmeldetag: 28.09.1988
(51) Int. Cl.: H01L 21/00, B08B 11/04

(54) **Verfahren zum Reinigen insbesondere von scheibenförmigen oxidischen Substraten**
Procedure for cleaning, in particular disc-shaped oxidized susbtrates
Procédé pour le nettoyage, en particulier de susbtrats oxydés en forme de disque

(30) Priorität: 05.10.1987 DE 3733670
(43) Veröffentlichungstag der Anmeldung: 12.04.1989
(73) Patentinhaber: Angewandte Solarenergie - ASE GmbH, D-63755 Alzenau (DE)
(72) Erfinder: Lenck, Norbert, D-6458 Rodenbach 1 (DE); Wörner, Jörg, Dr. Dipl.-Chem., D-6451 Grosskrotzenburg (DE)
(74) Vertreter: Stoffregen, Hans-Herbert, Dr. Dipl.-Phys.

(56) Entgegenhaltungen:
- US-A- 4 643 774
- US-A- 4 643 774
- PATENT ABSTRACTS OF JAPAN, Band 10, Nr. 82 (E-392)[2139], 2. April 1986;& JP-A-60 229 339
- PATENT ABSTRACTS OF JAPAN, Band 9, Nr. 321 (E-367)[2044], 17. Dezember 1985;& JP-A-60 154 531

## Beschreibung

Die Erfindung bezieht sich auf ein Verfahren zum Reinigen insbesondere von scheibenförmigen oxidischen Substraten wie Glas.

Sofern auf oxidische Substrate wie z. B. Gläser elektrische, optische oder funktionelle Schichten aufgetragen werden sollen, müssen zuvor anhaftende organische und anorganische Verunreinigungen entfernt werden. Hierzu gibt es im wesentlichen zwei Reinigungsverfahren. So ist es bekannt, scheibenförmige Gläser auf Rollen durch eine Bürstenstrecke zu transportieren, wobei in mehreren Reinigungsstufen tensidhaltiges Wasser und sodann vollentsalztes Wasser (VE-Wasser) auf die Oberflächen gesprüht werden. Um Flüssigkeitsrückstände zu beseitigen, erfolgt ein Trockenblasen. Nachteil dieses Verfahrens ist es, daß die Substrate gegen den Bürstendruck durch entsprechende Vorrichtung transportiert werden müssen, so daß Transportelemente wie Transportrollen, durch die eine Förderung durch die Vorrichtungen erfolgt, fest an die Scheiben zu drücken sind. Eine solche Handhabung führt zu Rückständen auf den Oberflächen. Um diesen Nachteil zu beseitigen, ist nach dem DE-GM 85 25 160 vorgeschlagen worden, daß die Substrate im wesentlichen aufrechtstehend durch die Reinigungsstufen gefördert werden. Durch entsprechende technisch aufwendige Maßnahmen kann jedoch nicht sichergestellt werden, daß die Oberflächen durch das mechanische Einwirken der Bürstenenden hinreichend gereinigt werden, da die aufzusprühenden Flüssigkeiten für sich nicht notwendigerweise ausreichen, um Verunreinigungen zu entfernen. In der anschließenden Trocknungsstufe wird Luft im wesentlichen senkrecht auf die Oberfläche der Substrate geleitet. Hierdurch entstehen Verwirbelungen, durch die unerwünschterweise Verunreinigungspartikel erneut auf die Oberfläche aufgebracht werden können. Infolgedessen sind mit großem Aufwand zu betreibende Luftreinigungsstationen erforderlich, um eine Partikelkontamination zu verhindern.

Zum anderen besteht die Möglichkeit, die Substrate in verschiedenen Bädern mit Ultraschall und Tensiden -üblicherweise in hohen Konzentrationen- zu reinigen. Anschließend erfolgt zur Entwässerung ein Nachspülen mit organischen Lösungsmitteln. Das Trocknen erfolgt sodann in einem halogenierten Kohlenwasserstoff-Dampfbad. Bei diesem Verfahren treten nachteilig große Tensidrückstände auf den Substratoberflächen auf, die nur schwer vollständig entfernt werden können, so daß Haftungsprobleme bei den aufzubringenden Schichten erwachsen. Zudem wird der Einsatz von halogenierten Kohlenwasserstoffen allein aus Umweltschutzüberlegungen zunehmend schwieriger, da aus Gründen der Arbeitsplatzsicherheit eine überaus gründliche Absaugung erforderlich ist. Folglich sind zur Reinigung Abluft und zur Rückgewinnung der halogenierten Kohlenwasserstoffe aus den Badverlusten und den Abdampfverlusten von Trockengut hohe Investitionskosten erforderlich. Auch hat eine aufwendige Entsorgung der Lösungsmittelabfälle zu erfolgen, da diese auf hohe Temperaturen gebracht werden müssen.

Aus der US-A-4,643,774 ist ein Verfahren und eine Vorrichtung zum Waschen und Trocknen von insbesondere Halbleiterelementen bekannt. Zum Reinigen werden die Halbleiterelemente in einer Reinigungsflüssigkeit in Schwingung versetzt und vibrierend aus dieser herausgezogen. Gleichzeitig wird das Halbleiterelement zu dessen Trocknen mit Gas beaufschlagt, um möglichst schnell Reste von Reinigungsflüssigkeit zu entfernen.

Der Patent Abstracts of Japan, Band 10, Nr. 82 (E-392), 2139, 2. April 1986; JP-A-60 229 339 ist eine Waschvorrichtung für Materialien zu entnehmen, bei der auf der Oberfläche der Waschflüssigkeit eine gezielte Strömung erzeugt wird, um Schmutzpartikel wegzuspülen, die von dem zu reinigenden Substrat innerhalb der Flüssigkeit entfernt werden.

Aufgabe der vorliegenden Erfindung ist es, ein Verfahren der eingangs genannten Art so auszubilden, daß mit einfachen Maßnahmen ein den Anforderungen voll genügendes Reinigen der Substrate erfolgt, ohne daß eine mechanische Beschädigung erfolgt, und ohne daß Trocknungsrückstände oder Ablaufspuren auftreten. Dabei soll gleichzeitig die Verwendung von halogenierten Kohlenwassersotffen unterbleiben.

Die Aufgabe wird nach dem Verfahren gemäß dem Anspruch 1 dadurch gelöst, daß das Substrat nach einer Vorreinigung aus einer Wasservorlage im wesentlichen senkrecht zu derer Oberfläche derart herausgezogen wird, daß zum Reinigen des Substrats ein zusammenhängender sich zur Wasseroberfläche erstreckender Feuchtigkeitsfilm von der Oberfläche des Substrats abläuft, wobei die Oberfläche der Wasservorlage unabhängig von der Eintauchtiefe des Substrats auf einem im wesentlichen gleichbleibenden Niveau gehalten wird. Dabei kann das Substrat, bevor es in die Wasservorlage gelangt, in einer schwach tensidhaltigen Lösung gegebenenfalls um Ultraschallbad vorgereinigt werden. Innerhalb der Wasservorlage selbst wird das Substrat auf eine gewünschte Temperatur T₁ eingestellt, wobei T₁ zwischen 50°C und 95°C, insbesondere zwischen 60°C und 80°C liegt. Hat das Substrat die Temperatur angenommen und wird es mit Geschwindigkeiten zwischen 0,1 mm/sec und 10 mm/sec aus der Wasservorlage herausgezogen, so bildet sich ein zusammenhängender Wasserfilm, der gleichmäßig von der Oberfläche abläuft.

Da die Oberfäche der Wasservorlage beim Herausziehen des Substrats auf einem konstanten Niveau gehalten wird, werden durch Flüssigkeitsverdrängungen bedingte Schwankungen, die sich negativ auf die Ausbildung des Wasserfilms auswirken können, vermieden.

Vorzugsweise unmittelbar oberhalb der Wasseroberfläche wird das Substrat beidseitig, vornehmlich durch IR-Strahler erwärmt, wodurch sichergestellt ist, daß eine Kondensation von Wasserdampf auf der Substratoberfläche unterbleibt. Unterstützt wird dies durch ein entlang der Substratoberfläche strömendes Gas, insbesondere von hochgereinigter Luft laminarer Strömung.

Eine Vorrichtung zur Durchführung insbesondere des zuvor beschriebenen Verfahrens zeichnet sich dadurch aus, daß die Vorrichtung eine in einem Behältnis vorhandene Wasservorlage umfaßt, daß das Behältnis zumindest einen seitlichen Überlauf aufweist, daß die Wasservorlage mit einer Wasserversorgung verbunden ist, daß oberhalb der Wasservorlage zumindest zwei zueinander beabstandete Heizelemente angeordnet sind, zwischen denen das Substrat bewegbar ist, und daß die Vorrichtung eine Zuführung für hochgereinigte entlang des Substrats strömende Luft aufweist. Vorzugsweise sind die Elemente in einem Gehäuse angeordnet. Auch können zwei diametral zu dem Substrat angeordnete Überläufe vorgesehen sein, die von Kanälen ausgehen können, über die die das Substrat umspülende Luft abführbar ist. Ist der Bereich oberhalb der Wasservorlage nicht von einem Gehäuse umgeben, sollte sich die Wasservorlage in einem Reinraum oder in einem Flow-Arbeitsplatz befinden.

Das der Wasservorlage zuzuführende Wasser ist hoch rein (DI-Wasser), das durch die Wasservorlage im Kreislauf geführt und vorgewärmt wird. Dabei befindet sich innerhalb des Kreislaufs eine Filtereinrichtung, um zu Verunreinigungen führende Partikel zurückzuhalten.

Mit dem erfindungsgemäßen Verfahren ist es möglich, vorgereinigte Substrate einzig und allein mit Wasser zu reinigen, wobei hinsichtlich der Oberflächenreinheit im Vergleich zu den bekannten Verfahren optimale Ergebnisse erzielt werden.

Es zeigen:

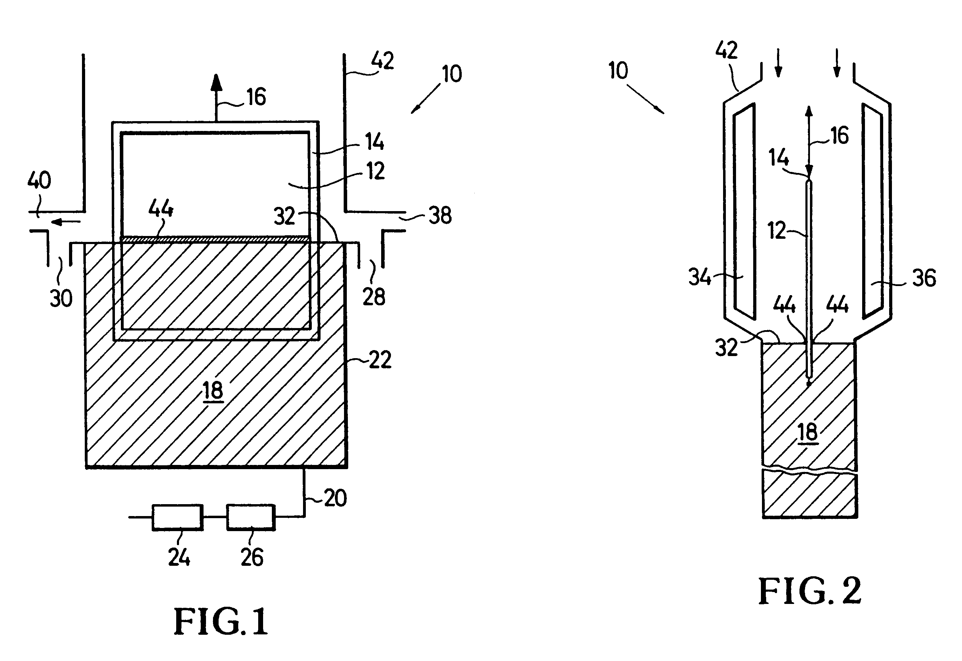

- Fig. 1: eine schematische Seitendarstellung einer Vorrichtung zur Durchführung des beanspruchten Verfahren im Schnitt und
- Fig. 2: einen Längsschnitt durch die Vorrichtung nach Fig. 1.

In den Figuren ist eine Vorrichtung (10) dargestellt, in der scheibenförmige Substrate (12) gereinigt werden sollen. Bei den Substraten (12) handelt es sich vorzugsweise um oxidische Substrate, wie z.B. Gläser. Das Substrat (12) ist von einer Halterung wie Rahmen (14) aufgenommen, um in Richtung des Pfeils (16) aus einer Flüssigkeitsvorlage (18) herausgezogen zu werden. Bei der Flüssigkeitsvorlage (18) handelt es sich um hochgereinigtes Wasser (DI-Wasser), das über eine Leitung (20) einem Behältnis (22) zugeführt wird. In der Leitung (20) befindet sich eine Heizung (24) sowie eine Filtereinrichtung (26). Das Behältnis (22) wie Becken weist im Ausführungsbeispiel zwei Überläufe (28) und (30) auf, die zu dem Substrat (12) diametral und vorzugsweise im Bereich der Ebene angeordnet sind, die von dem Substrat (12) aufgespannt wird. Das von den Überläufen (28) und (30) entnommene Wasser wird im Kreislauf der Leitung (20) zugeführt. Durch die Überläufe (28) und (30) ist sichergestellt, daß sich die Oberfläche (32) der Wasservorlage (18) stets auf gleichem Niveau befindet.

Seitlich von dem Substrat (12) oberhalb der Oberfläche (32) befinden sich Heizelemente, insbesondere IR-Strahler (34) und (36). Von der Oberseite der Vorrichtung wird hochgereinigtes Gas wie Luft zugeführt, das zwischen den IR-Strahlern (34) und (36) entlang der Oberfläche des Substrats (12) strömt, um über Kanäle (38) und (40) abgeführt zu werden, von denen auch die Überläufe (28) und (30) ausgehen.

Wie die zeichnerische Darstellung erkennen läßt, befinden sich die zuvor beschriebenen Elemente in einem Gehäuse (42). Dies ist jedoch nicht notwendigerweise erforderlich. Vielmehr kann das Behältnis (22) mit der Wasservorlage (18) auch in einem Rein-Raum oder in einem Flow-Arbeitsplatz angeordnet sein.

Um das Substrat (12) zu reinigen, wird es zunächst in einer tensidhaltigen Lösung und vorzugsweise im Ultraschallbad vorgereinigt. Sodann wird das Substrat (12) vollständig in die Wasservorlage (18) eingetaucht. Die Wasservorlage selbst wird auf eine gewünschte Temperatur T₁ vorzugsweise zwischen 50°C und 95°C, insbesondere zwischen 60°C und 80°C eingestellt. Sobald das Substrat (12) die Temperatur T₁ angenommen hat, wird es in Richtung des Pfeils (16) aus dem hochgereinigten Wasser herausgezogen. Als Ziehgeschwindigkeiten sind Werte zwischen 0,1 mm/sec und 10 mm/sec anzugeben. Unter Beachtung dieser Parameter bildet sich ein gleichmäßiger Wasserfilm (44) auf beiden Seiten des Substrats, der von der Wasseroberfläche (32) ausgeht. Der Wasserfilm (44) läuft gleichmäßig von der Oberfläche des Substrats (12) ab, ohne abzureißen. Hierdurch ist sichergestellt, daß Substrat (12) im erforderlichen Umfang gereinigt ist, um anschließend z.B. elektrische, optische oder funktionelle Schichten auftragen zu können. Um zu gewährleisten, daß der oberhalb der Wasservorlage (18) befindliche Wasserdampf nicht auf der gereinigten Oberfläche des Substrats (12) kondensiert, erfolgt unmittelbar oberhalb der Wasseroberfläche (32) eine Aufwärmung auf eine Temperatur, die oberhalb der der Wasservorlage (18) liegt. Diese Erwärmung wird durch die zu beiden Seiten des Substrats (12) angeordneten IR-Strahler (34) und (36) vorgenommen. Unterstützt wird das Unterbinden einer Kondensatbildung auf der Oberfläche durch die hochgereinigte Luft laminarer Strömungen, die entlang der Substratoberfläche geleitet und über die Kanäle (38) und (40) abgeführt wird.

Mit dem erfindungsgemäßen Verfahren können selbstverständlich nicht nur oxidische Substrate, sondern auch nichtoxidische Substrate gereinigt werden. Letzteres ist dann möglich, wenn eine Korrosion durch die Wasservorlage ausgeschlossen ist. Durch Einstellung des pH-Wertes kann dies ermöglicht werden.

Auch kann ein bereits vorgereinigtes Substrat dem Verfahren unterworfen werden. Dabei kann die Vorreinigung zum Beispiel von einem Hersteller des Substrats vorgenommen sein.

## Patentansprüche

1. Verfahren zum Reinigen insbesondere von scheibenförmigen oxidischen Substraten wie Glas, wobei das Substrat zumindest eine Reinigungs- und eine Trockenstufe durchläuft,
**dadurch gekennzeichnet**,
daß das Substrat nach einer Vorreinigung in einer Wasservorlage auf eine gewünschte Temperatur T₁ eingestellt wird, wobei T₁ zwischen 50°C und 95°C, insbesondere zwischen 60°C und 80°C liegt, und anschließend das Substrat im wesentlichen senkrecht zur Oberfläche mit einer Geschwindigkeit zwischen 0,1 mm/sec und 10 mm/sec aus der Wasservorlage herausgezogen wird, so daß ein zusammenhängender sich zur Wasseroberfläche erstreckender Feuchtigkeitsfilm von der Oberfläche des Substrats abläuft.

2. Verfahren nach Anspruch 1,
**dadurch gekennzeichnet**,
daß das Substrat oberhalb der Wasseroberfläche auf eine oberhalb der Temperatur T₁ der Wasservorlage liegende Temperatur T₂ erwärmt wird.

3. Verfahren nach Anspruch 1,
**dadurch gekennzeichnet**,
daß das Substrat von einer partikelarmen Luft laminarer Strömung umspült wird, deren Strömungsgeschwindigkeit vorzugsweise zwischen 0,1 m/sec und 0,5 m/sec liegt.

4. Verfahren nach Anspruch 1,
**dadurch gekennzeichnet**,
daß die Oberfläche der Wasservorlage unäbhängig von der Eintauchtiefe des Substrats auf einem im wesentlichen gleichbleibenden Niveau eingestellt wird.

## Claims

1. Method for cleaning in particular disc-shaped oxide substrates such as glass, whereas the substrate passes through at least one cleaning stage and one drying stage,
**characterized in**
that the substrate is set to a required temperature T₁ in a water quantity after pre-cleaning, whereas T₁ is between 50°C and 95°C, especially between 60°C and 80°C, and subsequently said substrate is extracted substantially vertically to the surface of the water quantity with a velocity between 0,1 mm/sec and 10 mm/sec, so a coherent film of moisture extending to the water surface runs off the surface of the substrate.

2. Method acording to Claim 1,
that the substrate is heated above the the water surface at a temperature T₂ exceeding the temperature t₁ of the of the water quantity.

3. Method according to Claim 1,
**characterized in**
that the substrate is swept by low-particle air of laminar flow, flow velocity of which is preferably between 0,1 m/sec and 0,5 m/sec.

4. Method according to Claim 1,
**characterized in**
that the surface of the water quantity is set to a substantially constant level being independent of the immersion depth of the substrate.

## Revendications

1. Procédé de nettoyage en particulier de substrats oxydés en forme de disque, tels que du verre, le substrat subissant au moins une séquence de nettoyage et une séquence de séchage, procédé caractérisé en ce que l'on met le substrat, après nettoyage dans un barboteur à eau, à une température T₁ voulue, T₁ étant comprise entre 50°C et 95°C, en particulier entre 60°C et 80°C, et on retire ensuite le substrat du barboteur à eau de façon sensiblement perpendiculaire à la surface à une vitesse comprise entre 0,1 mm/sec. et 10 mm/sec. de telle sorte qu'un film d'humidité adhésif s'étendant en direction de la surface de l'eau s'écoule de la surface du substrat.

2. Procédé selon la revendication 1, caractérisé en ce que le substrat est réchauffé au-dessus de la surface de l'eau à une température T₂ qui se trouve au-dessus de la température T₁ du barboteur à eau.

3. Procédé selon la revendication 1, caractérisé en ce que le substrat 1 est rincé par un écoulement laminaire d'air contenant peu de particules, écoulement dont la vitesse est de préférence comprise entre 0,1 m/sec et 0,5 m/sec.

4. Procédé selon la revendication 1, caractérisé en ce que la surface du barboteur à eau est réglée à un niveau sensiblement constant indépendamment de la profondeur d'immersion du substrat.
